# DEMANDE DE BREVET EUROPEEN

(11) **EP 4 386 875 A1**
(43) Date de publication de la demande: **19.06.2024**
(21) Numéro de dépôt: 23214656.3
(22) Date de dépôt: 06.12.2023
(51) Int. Cl.: H01L 31/18

(54) **PROCÉDÉ DE FABRICATION D'UNE CELLULE PHOTOVOLTAÏQUE**

(30) Priorité: 16.12.2022 FR 2213602
(71) Demandeur: Commissariat à l'énergie atomique et aux énergies alternatives, 75015 Paris (FR)
(72) Inventeur: HARRISON, Samuel, 38054 Grenoble cedex 09 (FR); ALBARIC, Mickaël, 38054 Grenoble cedex 09 (FR); GIGLIA, Valentin, 38054 Grenoble cedex 09 (FR); MARTEL, Benoît, 38054 Grenoble cedex 09 (FR); VEIRMAN, Jordi, 38054 Grenoble cedex 09 (FR)
(74) Mandataire: INNOV-GROUP

(57) **Abrégé**

Procédé de fabrication d'une cellule photovoltaïque, comportant les étapes :
a) utiliser une cellule photovoltaïque initiale, comprenant :
- un substrat (1), à base de silicium cristallin, et présentant :
des premier et deuxième bords latéraux opposés,
des troisième et quatrième bords latéraux opposés, reliant les premier et deuxième bords latéraux ;

- un empilement (2) de couches actives (20), formé autour du substrat (1), et comprenant une couche de passivation initiale (P0) possédant une vitesse de recombinaison de surface effective, notée SRV₀ .

## Description

### Domaine technique

L'invention se rapporte au domaine technique des cellules photovoltaïques, en particulier des cellules photovoltaïques comportant un contact passivé sur chacune des surfaces du substrat.

La passivation des surfaces du substrat est un enjeu majeur du secteur photovoltaïque, permettant de limiter les recombinaisons entre les porteurs minoritaires et majoritaires, et donc d'augmenter le nombre de porteurs collectés, ce qui se traduit par une amélioration significative de l'efficacité. Par « passivation », on entend la neutralisation de défauts électriquement actifs aux surfaces du substrat. En effet, une surface d'un substrat en silicium cristallin présente une densité de défauts (e.g. liaisons pendantes, impuretés, discontinuité du cristal etc.) pouvant entraîner des pertes non négligeables liées à la recombinaison en surface des porteurs dans le cas d'une application photovoltaïque.

Il existe plusieurs types de contacts passivés. On peut citer notamment un contact passivé à base de silicium amorphe hydrogéné, ou encore un contact passivé comportant un film d'oxyde tunnel et une couche de silicium polycristallin dopé.

L'invention trouve notamment son application dans la fabrication de cellules photovoltaïques de type silicium à hétérojonction (i.e. hétérojonction silicium amorphe/silicium cristallin). Cependant, d'autres architectures de cellule photovoltaïque sont envisageables, par exemple une architecture de type TOPCon (« *Tunnel Oxide Passivated Contact»* en langue anglaise) où le contact passivé comporte un fim d'oxyde tunnel et une couche de silicium polycristallin dopé, ou encore une architecture de type multi-jonction monolithique (e.g. cellule tandem silicium/pérovskite).

### État de l'art

Un procédé de fabrication d'une cellule photovoltaïque connu de l'état de la technique, comporte les étapes :
A) utiliser une cellule photovoltaïque initiale, comprenant :
   - un substrat, à base de silicium cristallin, et présentant :
      des premier et deuxième bords latéraux opposés,
      des troisième et quatrième bords latéraux opposés, reliant les premier et deuxième bords latéraux ;
   - un empilement de couches actives, formé autour du substrat, et comprenant une couche de passivation initiale, l'empilement présentant :
      des première et deuxième parties latérales, s'étendant respectivement sur les premier et deuxième bords latéraux du substrat,
      des troisième et quatrième parties latérales, s'étendant respectivement sur les troisième et quatrième bords latéraux du substrat ;
B) découper le substrat suivant au moins une ligne de découpe s'étendant dans une région centrale du substrat de manière à obtenir au moins deux sous-cellules photovoltaïques ;
C) revêtir chaque bord découpé [à l'issue de l'étape B)] des sous-cellules photovoltaïques d'une couche de passivation dédiée.

Le premier bord latéral du substrat et la première partie latérale de l'empilement de couches actives constituent un bord dit natif de la cellule photovoltaïque initiale. Le deuxième bord latéral du substrat et la deuxième partie latérale de l'empilement de couches actives constituent également un bord natif de la cellule photovoltaïque initiale. De la même façon, le troisième bord latéral du substrat et la troisième partie latérale de l'empilement de couches actives constituent un bord natif de la cellule photovoltaïque initiale. Enfin, le quatrième bord latéral du substrat et la quatrième partie latérale de l'empilement de couches actives constituent un bord natif de la cellule photovoltaïque initiale.

Un tel procédé de l'état de la technique n'est pas entièrement satisfaisant dans la mesure où les performances simulées des sous-cellules photovoltaïques, en termes de rendement, diminuent d'autant plus que les dimensions finales de la sous-cellule photovoltaïque sont réduites. Ces pertes de performances sont en particulier préjudiciables pour les sous-cellules photovoltaïques possédant un format réduit, compatible avec la technologie d'interconnexions en bardeaux (« *Shingle»* en langue anglaise).

### Exposé de l'invention

L'invention vise à remédier en tout ou partie aux inconvénients précités. A cet effet, l'invention a pour objet un procédé de fabrication d'une cellule photovoltaïque, comportant les étapes :
a) utiliser une cellule photovoltaïque initiale, comprenant :
   - un substrat, à base de silicium cristallin, et présentant :
      des premier et deuxième bords latéraux opposés,
      des troisième et quatrième bords latéraux opposés, reliant les premier et deuxième bords latéraux ;
   - un empilement de couches actives, formé autour du substrat, et comprenant une couche de passivation initiale possédant une vitesse de recombinaison de surface effective, notée SRV₀ ; l'empilement présentant :
      des première et deuxième parties latérales, s'étendant respectivement sur les premier et deuxième bords latéraux du substrat,
      des troisième et quatrième parties latérales, s'étendant respectivement sur les troisième et quatrième bords latéraux du substrat ;
b₁) retirer la première partie latérale de l'empilement de couches actives de manière à atteindre le premier bord latéral du substrat ;
c₁) former une première couche de passivation sur le premier bord latéral du substrat atteint à l'issue de l'étape b₁), la première couche de passivation possédant une vitesse de recombinaison de surface effective strictement inférieure à SRV₀.

Ainsi, un tel procédé selon l'invention permet d'améliorer la qualité de passivation des sous-cellules photovoltaïques qui seront obtenues après l'étape c₁), et ce grâce aux étapes b₁) et c₁) permettant de remplacer le bord natif de la cellule photovoltaïque initiale, formé par le premier bord latéral du substrat et la première partie latérale de l'empilement de couches actives. La première couche de passivation, possédant une vitesse de recombinaison de surface effective strictement inférieure à SRVo, est de meilleure qualité que la couche de passivation initiale.

En effet, les inventeurs ont constaté, de manière surprenante, que les performances des sous-cellules photovoltaïques sont limitées par la qualité de la passivation des bords natifs de la cellule photovoltaïque initiale. Or, l'homme du métier conserve classiquement les bords natifs de la cellule photovoltaïque initiale et se concentre sur la passivation des bords découpés lors de l'obtention de sous-cellules photovoltaïques fonctionnelles. Or, les bords natifs de la cellule photovoltaïque initiale sont relativement sensibles, et susceptibles de subir des chocs ou des rayures qui peuvent détériorer la qualité de passivation, et par là-même réduire le rendement des sous-cellules photovoltaïques. De plus, les bords natifs de la cellule photovoltaïque initiale présentent généralement une qualité de passivation intrinsèque inférieure à celle des surfaces supérieure et inférieure du substrat (qualité de dépôt, uniformité de couche etc.).

Le procédé selon l'invention peut comporter une ou plusieurs des caractéristiques suivantes.

Selon une caractéristique de l'invention, le procédé comporte les étapes :
bz) retirer la deuxième partie latérale de l'empilement de couches actives de manière à atteindre le deuxième bord latéral du substrat ;
c₂) former une deuxième couche de passivation sur le deuxième bord latéral du substrat atteint à l'issue de l'étape b₂), la deuxième couche de passivation possédant une vitesse de recombinaison de surface effective strictement inférieure à SRV₀.

Ainsi, un avantage procuré est d'améliorer la qualité de passivation des sous-cellules photovoltaïques qui seront obtenues après l'étape c₂), et ce grâce aux étapes b₂) et c₂) permettant de remplacer le bord natif de la cellule photovoltaïque initiale, formé par le deuxième bord latéral du substrat et la deuxième partie latérale de l'empilement de couches actives.

Selon une caractéristique de l'invention, le procédé comporte les étapes :
b₃) retirer la troisième partie latérale de l'empilement de couches actives de manière à atteindre le troisième bord latéral du substrat ;
c₃) former une troisième couche de passivation sur le troisième bord latéral du substrat atteint à l'issue de l'étape b₃), la troisième couche de passivation possédant une vitesse de recombinaison de surface effective strictement inférieure à SRV₀.

Ainsi, un avantage procuré est d'améliorer la qualité de passivation des sous-cellules photovoltaïques qui seront obtenues après l'étape c₃), et ce grâce aux étapes b₃) et c₃) permettant de remplacer le bord natif de la cellule photovoltaïque initiale, formé par le troisième bord latéral du substrat et la troisième partie latérale de l'empilement de couches actives.

Selon une caractéristique de l'invention, le procédé comporte les étapes :
b₄) retirer la quatrième partie latérale de l'empilement de couches actives de manière à atteindre le quatrième bord latéral du substrat ;
c₄) former une quatrième couche de passivation sur le quatrième bord latéral du substrat atteint à l'issue de l'étape b₄), la quatrième couche de passivation possédant une vitesse de recombinaison de surface effective strictement inférieure à SRV₀.

Ainsi, un avantage procuré est d'améliorer la qualité de passivation des sous-cellules photovoltaïques qui seront obtenues après l'étape c₄), et ce grâce aux étapes b₄) et c₄) permettant de remplacer le bord natif de la cellule photovoltaïque initiale, formé par le quatrième bord latéral du substrat et la quatrième partie latérale de l'empilement de couches actives. Les inventeurs ont constaté, par simulation, une augmentation potentielle de 0,1 % du rendement de la cellule photovoltaïque initiale (avant la formation de sous-cellules photovoltaïques) par bord natif remplacé.

Selon une caractéristique de l'invention :
- l'étape a) est exécutée de sorte que l'empilement de couches actives comprend une couche d'oxyde transparent conducteur superficielle présentant un décrochement initial, en retrait par rapport à chaque bord latéral du substrat, le décrochement initial étant de préférence obtenu par détourage ;
- l'étape b₁) est exécutée par une première découpe du substrat ajustée pour retirer la première partie latérale de l'empilement de couches actives et une première zone latérale du substrat, de sorte que le premier bord latéral du substrat atteint à l'issue de la première découpe fait face au décrochement initial de la couche d'oxyde transparent conducteur superficielle.

Ainsi, un avantage procuré est d'améliorer les performances de la cellule photovoltaïque initiale en supprimant totalement le décrochement initial (classiquement une zone de détourage) qui est une source de pertes électriques (ombrage électrique), en particulier pour une architecture de type silicium à hétérojonction.

Selon une caractéristique de l'invention, l'étape b₂) est exécutée par une deuxième découpe du substrat ajustée pour retirer la deuxième partie latérale de l'empilement de couches actives et une deuxième zone latérale du substrat, de sorte que le deuxième bord latéral du substrat atteint à l'issue de la deuxième découpe fait face au décrochement initial de la couche d'oxyde transparent conducteur superficielle.

Ainsi, un avantage procuré est d'améliorer les performances de la cellule photovoltaïque initiale en supprimant totalement le décrochement initial (classiquement une zone de détourage) qui est une source de pertes électriques (ombrage électrique), en particulier pour une architecture de type silicium à hétérojonction.

Selon une caractéristique de l'invention, l'étape b₃) est exécutée par une troisième découpe du substrat ajustée pour retirer la troisième partie latérale de l'empilement de couches actives et une troisième zone latérale du substrat, de sorte que le troisième bord latéral du substrat atteint à l'issue de la troisième découpe fait face au décrochement initial de la couche d'oxyde transparent conducteur superficielle.

Ainsi, un avantage procuré est d'améliorer les performances de la cellule photovoltaïque initiale en supprimant totalement le décrochement initial (classiquement une zone de détourage) qui est une source de pertes électriques (ombrage électrique), en particulier pour une architecture de type silicium à hétérojonction.

Selon une caractéristique de l'invention, l'étape b₄) est exécutée par une quatrième découpe du substrat ajustée pour retirer la quatrième partie latérale de l'empilement de couches actives et une quatrième zone latérale du substrat, de sorte que le quatrième bord latéral du substrat atteint à l'issue de la quatrième découpe fait face au décrochement initial de la couche d'oxyde transparent conducteur superficielle.

Ainsi, un avantage procuré est d'améliorer les performances de la cellule photovoltaïque initiale en supprimant totalement le décrochement initial (classiquement une zone de détourage) qui est une source de pertes électriques (ombrage électrique), en particulier pour une architecture de type silicium à hétérojonction.

Selon une caractéristique de l'invention, le substrat de la cellule photovoltaïque initiale utilisée lors de l'étape a) présente :
- une région centrale,
- une région périphérique, s'étendant autour de la région centrale, comprenant les premier et deuxième bords latéraux ainsi que les troisième et quatrième bords latéraux ;
le procédé comporte une étape d) consistant à découper le substrat suivant au moins une ligne de découpe s'étendant dans la région centrale de manière à obtenir au moins deux sous-cellules photovoltaïques.

Selon une caractéristique de l'invention, lesdites au moins deux sous-cellules photovoltaïques présentent des bords découpés à l'issue de l'étape d) ; le procédé comportant une étape e) consistant à revêtir chaque bord découpé à l'issue de l'étape d) d'une couche de passivation possédant une vitesse de recombinaison de surface effective strictement inférieure à SRV₀.

Selon une caractéristique de l'invention, l'étape a) est exécutée de sorte que la couche de passivation initiale est réalisée dans un silicium amorphe hydrogéné ; et l'étape c₁) est exécutée de sorte que la première couche de passivation est réalisée dans un oxyde d'aluminium.

Ainsi, bien que le silicium amorphe hydrogéné possède un potentiel de passivation généralement supérieur à celui de l'oxyde d'aluminium, la présence du silicium amorphe hydrogéné sur un bord latéral du substrat conduit à une moins bonne qualité de passivation intrinsèque (e.g. limitations en termes de dépôt et d'uniformité) et à une plus grande sensibilité aux chocs, dégradations, et contaminations. L'utilisation de l'oxyde d'aluminium permet donc de réduire la vitesse de recombinaison de surface effective par rapport au silicium amorphe hydrogéné présent sur un bord latéral. De plus, l'utilisation de l'oxyde d'aluminium, transparent optiquement, est avantageuse d'un point de vue intégration car l'oxyde d'aluminium peut être déposé sans incidence sur toute la surface latérale de la cellule photovoltaïque, au contraire du silicium amorphe. Par ailleurs, il est également possible d'envisager des dépôts localisés pour l'oxyde d'aluminium, ce qui est beaucoup plus complexe à mettre en oeuvre pour le silicium amorphe en nécessitant un masquage extérieur.

### Définitions

- Par « substrat », on entend un support physique, autoporté, destiné à la fabrication d'une cellule photovoltaïque. Le substrat peut être une tranche (« *wafer*» en langue anglaise) découpée dans un lingot de silicium cristallin.
- Par « silicium cristallin », on entend on entend la forme multicristalline ou la forme monocristalline du silicium, excluant donc le silicium amorphe.
- Par « à base de », on entend que le silicium cristallin est le matériau principal et majoritaire composant le substrat.
- Par « couche active », on entend une couche possédant un rôle dans le fonctionnement de la cellule photovoltaïque, par exemple un rôle de séparation de charges, un rôle de collecte de charges, un rôle de passivation électrique des surfaces du substrat, un rôle optique d'anti-reflets, un rôle de sous-cellule (autre que le silicium cristallin) dans le cas d'une multi-jonction etc.
- Par « couche », on entend une couche ou une pluralité de sous-couches de même nature.
- Par « passivation », on entend la neutralisation de défauts électriquement actifs aux surfaces du substrat. En effet, les surfaces d'un substrat en silicium cristallin présentent une densité de défauts (e.g. liaisons pendantes, impuretés, discontinuité du cristal...) pouvant entraîner des pertes non négligeables liées à la recombinaison en surface des porteurs dans le cas d'une application photovoltaïque.
- Par « vitesse de recombinaison de surface effective » (« *effective surface recombination velocity »* en langue anglaise), on entend la vitesse de recombinaison des porteurs de charges pour un flux de porteurs de charges traversant une surface effective (i.e. surface 'vue' par le rayonnement solaire).
- Par « de manière à atteindre », on entend que les étapes b₁), b₂), b₃) et b₄) sont exécutées de sorte que le bord latéral correspondant (ou éventuellement une portion attenante au bord latéral) est exposé à l'issue de l'étape correspondante.
- Par « sous-cellule photovoltaïque », on entend une cellule photovoltaïque obtenue à partir d'une découpe dans une région centrale du substrat de la cellule photovoltaïque initiale.
- Par « formé autour du substrat », on entend que l'empilement de couches actives est formé tout autour (autrement dit : entièrement autour) du substrat. Le substrat comporte un bord supérieur et un bord inférieur opposé, reliant quatre bords latéraux. En d'autres termes, l'empilement de couches actives est formé sur les bords supérieur et inférieur, ainsi que sur les quatre bords latéraux.

### Brève description des dessins

D'autres caractéristiques et avantages apparaîtront dans l'exposé détaillé de différents modes de réalisation de l'invention, l'exposé étant assorti d'exemples et de références aux dessins joints.

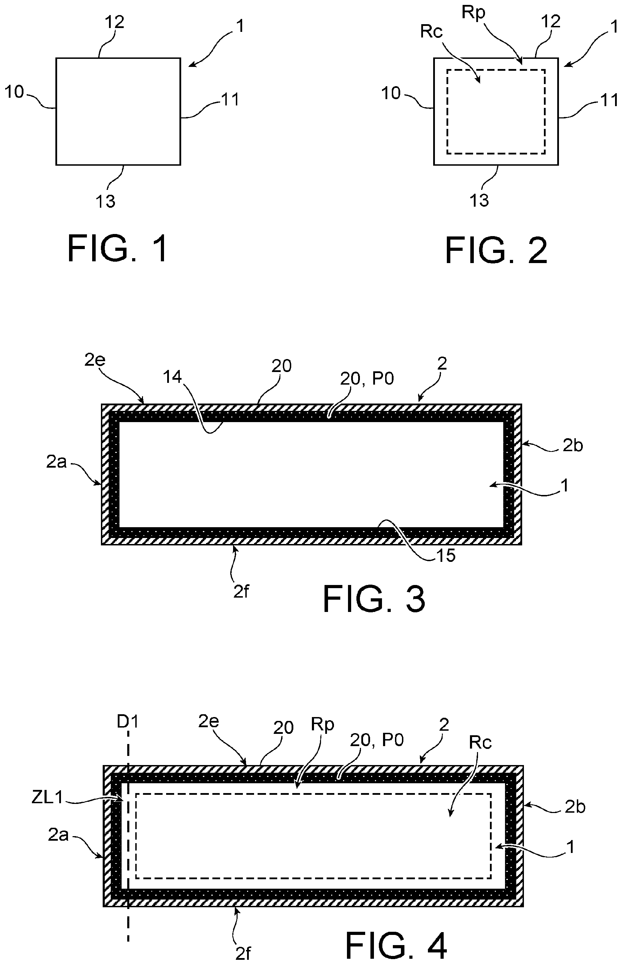

Figure 1 est une vue schématique de dessus, illustrant un substrat d'une cellule photovoltaïque initiale utilisée lors de l'étape a).
Figure 2 est une vue schématique de dessus, analogue à la figure 1, illustrant une région centrale et une région périphérique d'un substrat d'une cellule photovoltaïque initiale utilisée lors de l'étape a).
Figure 3 est une vue schématique en coupe (de manière à montrer les premier et deuxième bords latéraux du substrat), illustrant un empilement de couches actives formé autour d'un substrat d'une cellule photovoltaïque initiale utilisée lors de l'étape a). Certaines parties de l'empilement (en particulier les parties supérieure et inférieure) peuvent comporter des couches actives supplémentaires qui ne sont pas représentées par souci de simplicité.
Figure 4 est une vue schématique en coupe, analogue à la figure 3, illustrant l'étape b₁).

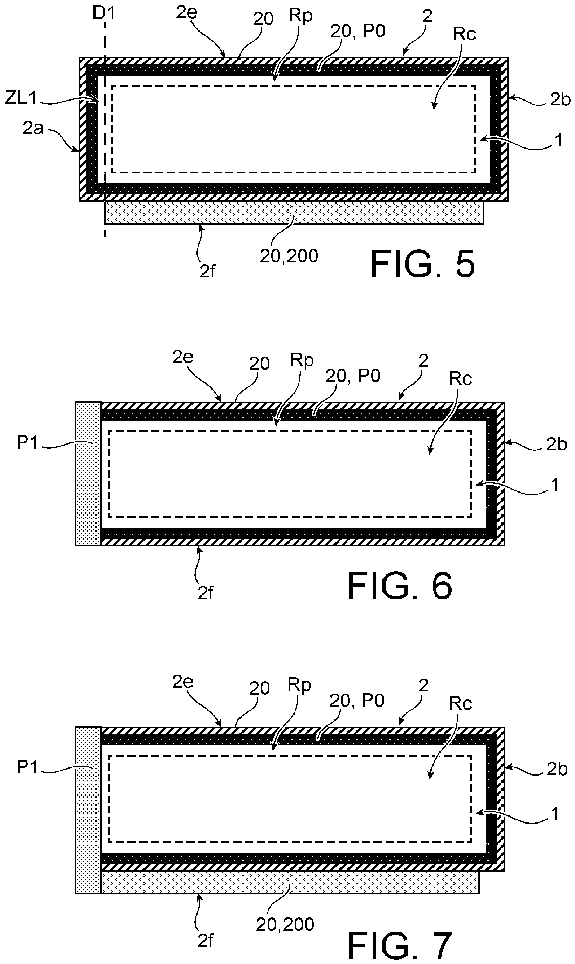

Figure 5 est une vue schématique en coupe, analogue à la figure 4, illustrant la présence d'une couche d'oxyde transparent conducteur superficielle détourée, appartenant à la partie inférieure de l'empilement.
Figure 6 est une vue schématique en coupe, illustrant l'étape c₁).
Figure 7 est une vue schématique en coupe, illustrant l'étape c₁) en présence d'une couche d'oxyde transparent conducteur superficielle détourée.

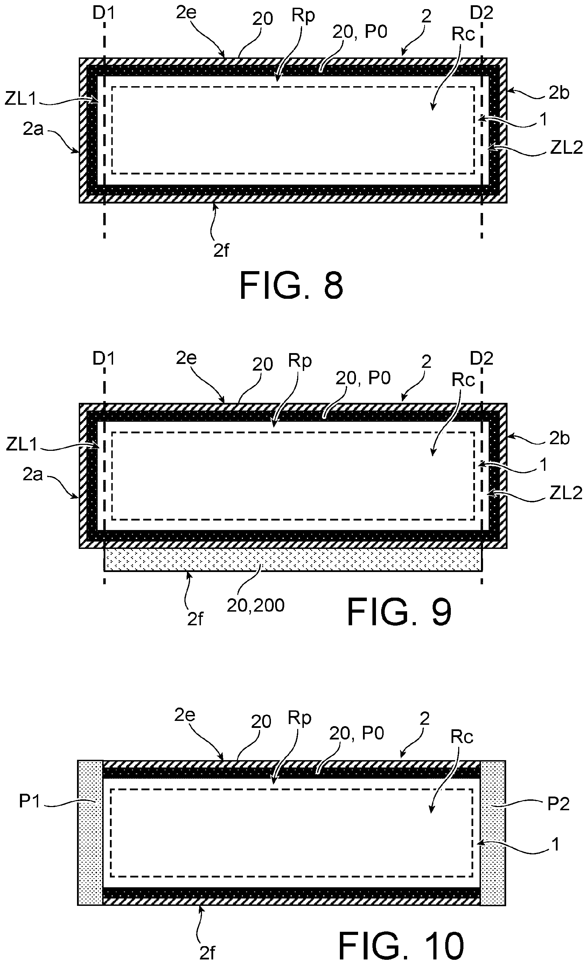

Figure 8 est une vue schématique en coupe, illustrant les étapes b₁) et b₂).
Figure 9 est une vue schématique en coupe, illustrant les étapes b₁) et b₂), en présence d'une couche d'oxyde transparent conducteur superficielle détourée.
Figure 10 est une vue schématique en coupe, illustrant les étapes c₁) et c₂).

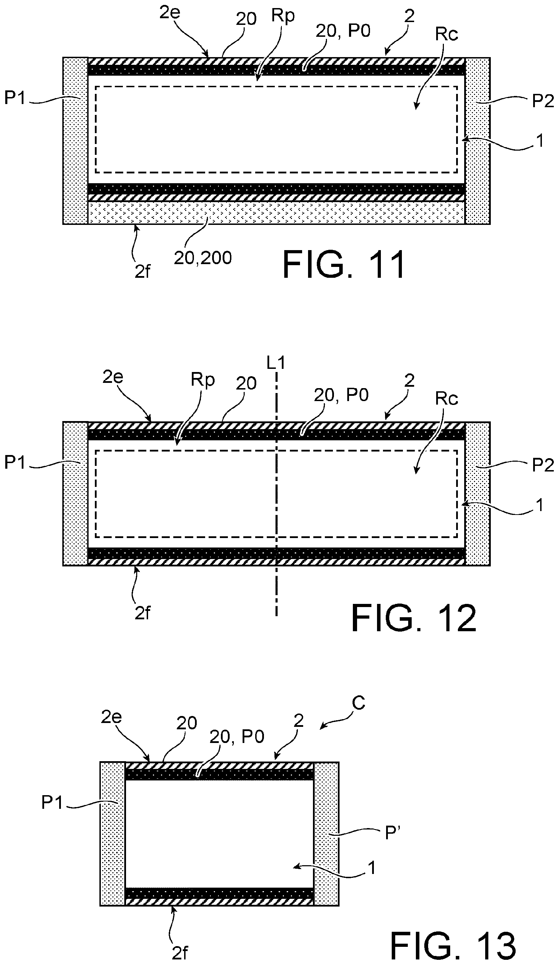

Figure 11 est une vue schématique en coupe, illustrant les étapes c₁) et c₂), en présence d'une couche d'oxyde transparent conducteur superficielle détourée.
Figure 12 est une vue schématique en coupe, illustrant un premier mode de mise en oeuvre de l'étape d) en conjugaison avec les étapes b₁), b₂), c₁), c₂).
Figure 13 est une vue schématique en coupe, illustrant une sous-cellule photovoltaïque obtenue à l'issue de l'étape d) illustrée à la figure 12, le bord découpé étant recouvert d'une couche de passivation.

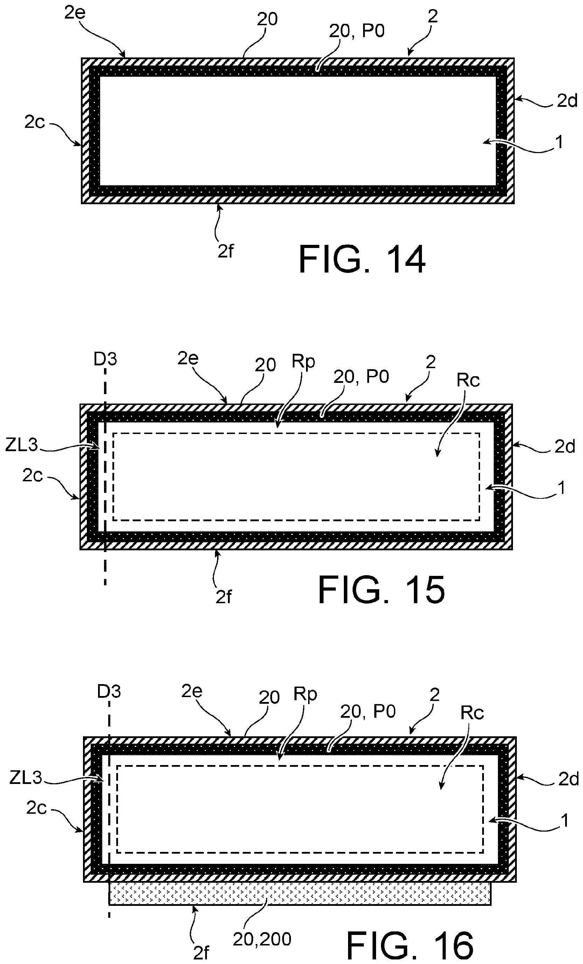

Figure 14 est une vue schématique en coupe (de manière à montrer les troisième et quatrième bords latéraux du substrat), illustrant un empilement de couches actives formé autour d'un substrat d'une cellule photovoltaïque initiale utilisée lors de l'étape a). Certaines parties de l'empilement (en particulier les parties supérieure et inférieure) peuvent comporter des couches actives supplémentaires qui ne sont pas représentées par souci de simplicité.
Figure 15 est une vue schématique en coupe, analogue à la figure 14, illustrant l'étape b₃).
Figure 16 est une vue schématique en coupe, analogue à la figure 15, illustrant la présence d'une couche d'oxyde transparent conducteur superficielle détourée, appartenant à la partie inférieure de l'empilement.

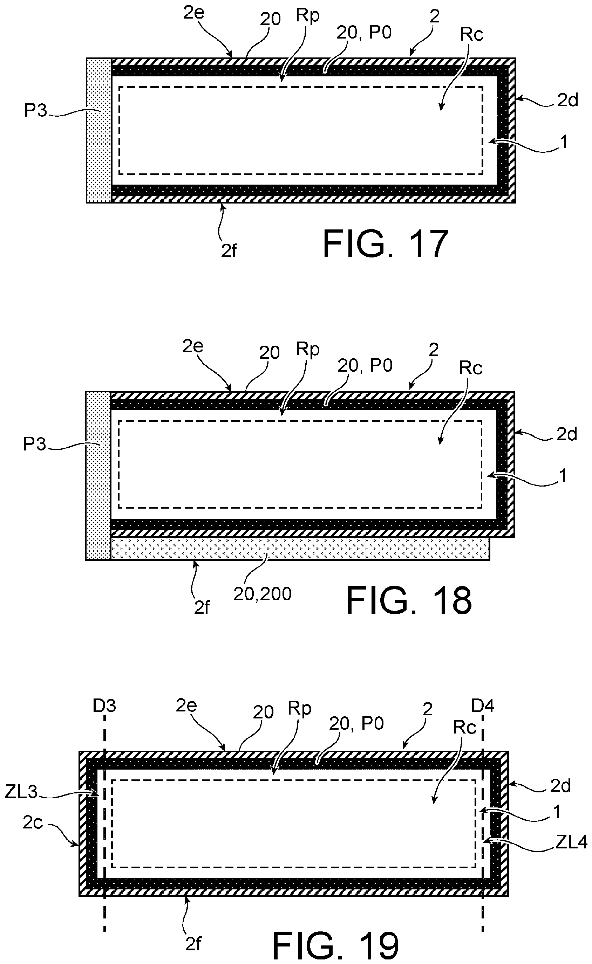

Figure 17 est une vue schématique en coupe, illustrant l'étape c₃).
Figure 18 est une vue schématique en coupe, illustrant l'étape c₃) en présence d'une couche d'oxyde transparent conducteur superficielle détourée.
Figure 19 est une vue schématique en coupe, illustrant les étapes b₃) et b₄).

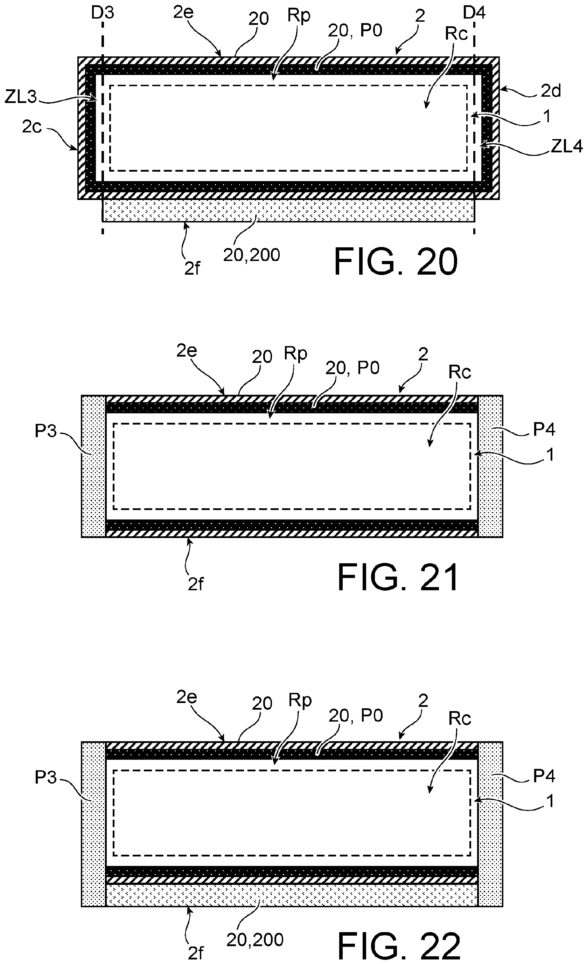

Figure 20 est une vue schématique en coupe, illustrant les étapes b₃) et b₄), en présence d'une couche d'oxyde transparent conducteur superficielle détourée.
Figure 21 est une vue schématique en coupe, illustrant les étapes c₃) et c₄).
Figure 22 est une vue schématique en coupe, illustrant les étapes c₃) et c₄), en présence d'une couche d'oxyde transparent conducteur superficielle détourée.

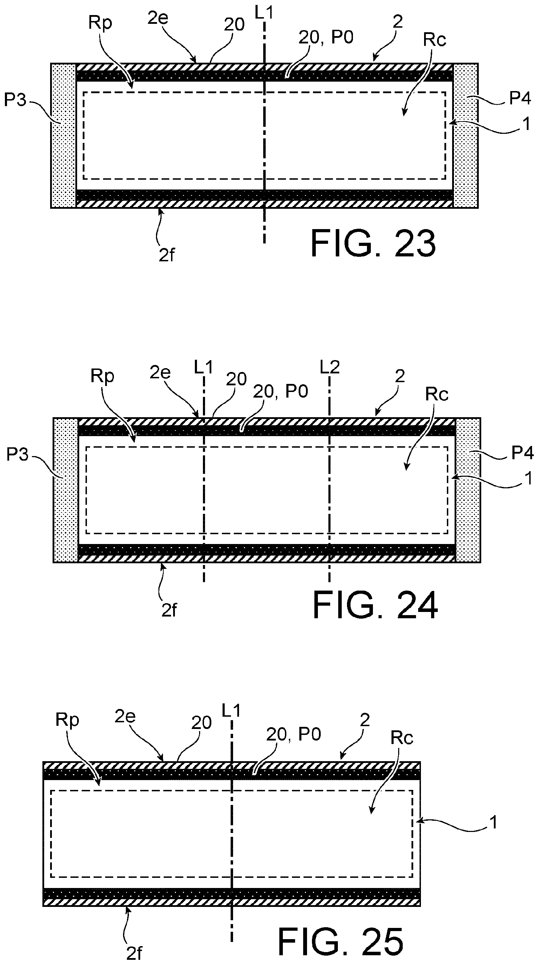

Figure 23 est une vue schématique en coupe, illustrant un mode de mise en oeuvre de l'étape d) en conjugaison avec les étapes b₃), b₄), c₃), c₄)
Figure 24 est une vue schématique en coupe, analogue à la figure 23, illustrant un autre mode de mise en oeuvre de l'étape d).
Figure 25 est une vue schématique en coupe, analogue à la figure 20, illustrant un mode de mise en oeuvre de l'étape d) après les étapes b₁) et b₂) [voire également après les étapes b₃) et b₄)] mais avant les étapes c₁) et c₂) [voire également avant les étapes c₃) et c₄)].

Il est à noter que les dessins décrits ci-avant sont schématiques, et ne sont pas nécessairement à l'échelle par souci de lisibilité et pour en simplifier leur compréhension. Les coupes sont effectuées selon la normale aux surfaces supérieure et inférieure du substrat.

### Exposé détaillé des modes de réalisation

Les éléments identiques ou assurant la même fonction porteront les mêmes références pour les différents modes de réalisation, par souci de simplification.

Un objet de l'invention est un procédé de fabrication d'une cellule photovoltaïque, comportant les étapes :
a) utiliser une cellule photovoltaïque initiale, comprenant :
   - un substrat 1, à base de silicium cristallin, et présentant :
      des premier et deuxième bords latéraux 10, 11 opposés,
      des troisième et quatrième bords latéraux 12, 13 opposés, reliant les premier et deuxième bords latéraux 10, 11 ;
   - un empilement 2 de couches actives 20, formé autour du substrat 1, et comprenant une couche de passivation initiale P0 possédant une vitesse de recombinaison de surface effective, notée SRV₀ ; l'empilement 2 présentant :
      des première et deuxième parties latérales 2a, 2b, s'étendant respectivement sur les premier et deuxième bords latéraux 10, 11 du substrat 1,
      des troisième et quatrième parties latérales 2c, 2d, s'étendant respectivement sur les troisième et quatrième bords latéraux 12, 13 du substrat 1 ;
b₁) retirer la première partie latérale 2a de l'empilement 2 de couches actives 20 de manière à atteindre le premier bord latéral 10 du substrat 1 ;
c₁) former une première couche de passivation P1 sur le premier bord latéral 10 du substrat 1 atteint à l'issue de l'étape b₁), la première couche de passivation P1 possédant une vitesse de recombinaison de surface effective strictement inférieure à SRV₀.

### Cellule photovoltaïque initiale

La cellule photovoltaïque initiale comprend un substrat 1 présentant :
- des premier et deuxième bords latéraux 10, 11 opposés,
- des troisième et quatrième bords latéraux 12, 13 opposés, reliant les premier et deuxième bords latéraux 10, 11 entre eux.

Le substrat 1 est à base de silicium cristallin. Le substrat 1 est avantageusement réalisé à base de silicium monocristallin, de préférence dopé de type n. Le substrat 1 comporte un bord supérieur 14 et un bord inférieur 15 opposé, reliant les bords latéraux 10, 11, 12, 13. Le bord supérieur 14 et/ou le bord inférieur 15 sont destinés à être exposés à un rayonnement lumineux. Le bord supérieur 14 peut être destiné à former la face avant de la cellule photovoltaïque, tandis que le bord inférieur 15 peut être destiné à former la face arrière de la cellule photovoltaïque.

La cellule photovoltaïque initiale comprend en outre un empilement 2 de couches actives 20, formé autour du substrat 1. L'empilement 2 de couches actives 20 comprend une couche de passivation initiale P0 possédant une vitesse de recombinaison de surface effective, notée SRV₀. La couche de passivation initiale P0 est formée sur les premier et deuxième bords latéraux 10, 11, sur les troisième et quatrième bords latéraux 12, 13, ainsi que sur les bords supérieur et inférieur 14, 15. A titre d'exemple non limitatif, la couche de passivation initiale P0 peut être réalisée dans un silicium amorphe hydrogéné, noté a-Si :H. Le silicium amorphe hydrogéné est intrinsèque.

L'empilement 2 de couches actives 20 présente :
- des première et deuxième parties latérales 2a, 2b, s'étendant respectivement sur les premier et deuxième bords latéraux 10, 11 du substrat 1,
- des troisième et quatrième parties latérales 2c, 2d, s'étendant respectivement sur les troisième et quatrième bords latéraux 12, 13 du substrat 1 ;
- des parties supérieure et inférieure 2e, 2f, s'étendant respectivement sur les bords supérieur et inférieur 14, 15 du substrat 1.

La couche de passivation initiale P0 des parties supérieure et inférieure 2e, 2f de l'empilement 2 de couches actives 20 peut posséder une vitesse de recombinaison de surface effective légèrement inférieure à celle des parties latérales 2a, 2b, 2c, 2d.

L'empilement 2 de couches actives 20 peut comporter une couche de séparation de charges formée sur la couche de passivation initiale P0. La couche de séparation de charges de la partie supérieure 2e de l'empilement 2 est dopée d'un premier type. La couche de séparation de charges de la partie inférieure 2f de l'empilement 2 est dopée d'un second type, opposé au premier type. A titre d'exemple non limitatif, la couche de séparation de charges peut être réalisée en a-Si :H. Les parties supérieure et inférieure 2e, 2f de l'empilement 2 peuvent comporter des couches actives 20 additionnelles (non illustrées), telles que des oxydes transparents conducteurs (e.g. l'oxyde d'indium-étain ITO), des plots métalliques formant des électrodes, des couches anti-reflet etc.

L'étape a) peut être exécutée de sorte que la partie inférieure 2f de l'empilement 2 comprend une couche d'oxyde transparent conducteur 200 superficielle présentant un décrochement initial, en retrait par rapport à chaque bord latéral 10, 11,12, 13 du substrat 1. Le décrochement initial est de préférence obtenu par détourage. Le décrochement initial peut être de l'ordre de 1 mm. A titre d'exemple non limitatif, la couche d'oxyde transparent conducteur 200 superficielle peut être réalisée en oxyde d'indium-étain ITO.

Le substrat 1 de la cellule photovoltaïque initiale utilisée lors de l'étape a) présente :
- une région centrale Rc,
- une région périphérique Rp, s'étendant autour de la région centrale Rc.

La région périphérique Rp comprend les premier et deuxième bords latéraux 10, 11 du substrat 1, ainsi que les troisième et quatrième bords latéraux 12, 13 du substrat 1. La région périphérique Rp comprend également les bords supérieur et inférieur 14, 15 du substrat 1.

Le premier bord latéral 10 du substrat 1 et la première partie latérale 2a de l'empilement 2 de couches actives 20 constituent un bord dit natif de la cellule photovoltaïque initiale. Le deuxième bord latéral 11 du substrat 1 et la deuxième partie latérale 2b de l'empilement 2 de couches actives 20 constituent également un bord natif de la cellule photovoltaïque initiale. De la même façon, le troisième bord latéral 12 du substrat 1 et la troisième partie latérale 2c de l'empilement 2 de couches actives 20 constituent un bord natif de la cellule photovoltaïque initiale. Enfin, le quatrième bord latéral 13 du substrat 1 et la quatrième partie latérale 2d de l'empilement 2 de couches actives 20 constituent un bord natif de la cellule photovoltaïque initiale.

Les bords supérieur et inférieur 14, 15 du substrat 1 présentent respectivement des surfaces supérieure et inférieure. Les surfaces supérieure et inférieure peuvent être planes. Les surfaces supérieure et inférieure peuvent être texturées afin de réduire le coefficient de réflexion et les pertes optiques dans la cellule photovoltaïque initiale.

### Retrait de bord(s) natif(s)

Le procédé comporte une étape b₁) consistant à retirer la première partie latérale 2a de l'empilement 2 de couches actives 20 de manière à atteindre le premier bord latéral 10 du substrat 1. L'étape b₁) est avantageusement exécutée par une première découpe D1 du substrat 1 ajustée pour retirer la première partie latérale 2a de l'empilement 2 de couches actives 20. La première découpe D1 est exécutée dans la région périphérique Rp du substrat 1. La première découpe D1 s'accompagne d'un retrait d'une première zone latérale ZL1 du substrat 1 s'étendant dans la région périphérique Rp du substrat 1. Ainsi, le premier bord latéral 10 du substrat 1 atteint à l'issue de l'étape b₁) ne coïncide pas parfaitement avec le premier bord latéral 10 initial. A titre d'exemple non limitatif, la distance entre le premier bord latéral 10 initial et le premier bord latéral 10 atteint à l'issue de l'étape b₁) peut être comprise entre 250 µm et 1,5 mm pour un substrat 1 de 300 mm de côté. La première découpe D1 est ajustée de sorte que la première zone latérale ZL1 présente une superficie la plus faible possible. Lorsque la partie inférieure 2f de l'empilement 2 comprend une couche d'oxyde transparent conducteur 200 superficielle présentant un décrochement initial, l'étape b₁) est avantageusement exécutée par une première découpe D1 du substrat 1 ajustée pour retirer la première partie latérale 2a de l'empilement 2 de couches actives 20 et une première zone latérale ZL1 du substrat 1, de sorte que le premier bord latéral 10 du substrat 1 atteint à l'issue de la première découpe D1 fait face au décrochement initial de la couche d'oxyde transparent conducteur 200 superficielle. A titre d'exemples non limitatifs, la première découpe D1 peut être exécutée par une technique de clivage laser (LDC pour « *Laser Direct Cleavage»* en langue anglaise), ou par une technique de séparation thermique au laser (TLS pour « *Thermal Laser Séparation* » en langue anglaise), ces techniques étant connues de l'homme du métier.

Le procédé comporte avantageusement une étape b₂) consistant à retirer la deuxième partie latérale 2b de l'empilement 2 de couches actives 20 de manière à atteindre le deuxième bord latéral 11 du substrat 1. L'étape b₂) est avantageusement exécutée par une deuxième découpe D2 du substrat 1 ajustée pour retirer la deuxième partie latérale 2b de l'empilement 2 de couches actives 20. La deuxième découpe D2 est exécutée dans la région périphérique Rp du substrat 1. La deuxième découpe D2 s'accompagne d'un retrait d'une deuxième zone latérale ZL2 du substrat 1 s'étendant dans la région périphérique Rp du substrat 1. Ainsi, le deuxième bord latéral 11 du substrat 1 atteint à l'issue de l'étape b₂) ne coïncide pas parfaitement avec le deuxième bord latéral 11 initial. A titre d'exemple non limitatif, la distance entre le deuxième bord latéral 11 initial et le deuxième bord latéral 11 atteint à l'issue de l'étape b₂) peut être comprise entre 250 µm et 1,5 mm pour un substrat 1 de 300 mm de côté. La deuxième découpe D2 est ajustée de sorte que la deuxième zone latérale ZL2 présente une superficie la plus faible possible. Lorsque la partie inférieure 2f de l'empilement 2 comprend une couche d'oxyde transparent conducteur 200 superficielle présentant un décrochement initial, l'étape b₂) est avantageusement exécutée par une deuxième découpe D2 du substrat 1 ajustée pour retirer la deuxième partie latérale 2b de l'empilement 2 de couches actives 20 et une deuxième zone latérale ZL2 du substrat 1, de sorte que le deuxième bord latéral 11 du substrat 1 atteint à l'issue de la deuxième découpe D2 fait face au décrochement initial de la couche d'oxyde transparent conducteur 200 superficielle. A titre d'exemples non limitatifs, la deuxième découpe D2 peut être exécutée par une technique de clivage laser (LDC pour « *Laser Direct Cleavage»* en langue anglaise), ou par une technique de séparation thermique au laser (TLS pour « *Thermal Laser Séparation »* en langue anglaise), ces techniques étant connues de l'homme du métier.

Le procédé comporte avantageusement une étape b₃) consistant à retirer la troisième partie latérale 2c de l'empilement 2 de couches actives 20 de manière à atteindre le troisième bord latéral 12 du substrat 1. L'étape b₃) est avantageusement exécutée par une troisième découpe D3 du substrat 1 ajustée pour retirer la troisième partie latérale 2c de l'empilement 2 de couches actives 20. La troisième découpe D3 est exécutée dans la région périphérique Rp du substrat 1. La troisième découpe D3 s'accompagne d'un retrait d'une troisième zone latérale ZL3 du substrat 1 s'étendant dans la région périphérique Rp du substrat 1. Ainsi, le troisième bord latéral 12 du substrat 1 atteint à l'issue de l'étape b₃) ne coïncide pas parfaitement avec le troisième bord latéral 12 initial. A titre d'exemple non limitatif, la distance entre le troisième bord latéral 12 initial et le troisième bord latéral 12 atteint à l'issue de l'étape b₃) peut être comprise entre 250 µm et 1,5 mm pour un substrat 1 de 300 mm de côté. La troisième découpe D3 est ajustée de sorte que la troisième zone latérale ZL3 présente une superficie la plus faible possible. A titre d'exemples non limitatifs, la troisième découpe D3 peut être exécutée par une technique de clivage laser (LDC pour « *Laser Direct Cleavage »* en langue anglaise), ou par une technique de séparation thermique au laser (TLS pour *« Thermal Laser Séparation »* en langue anglaise), ces techniques étant connues de l'homme du métier.

Le procédé comporte avantageusement une étape b₄) consistant à retirer la quatrième partie latérale 2d de l'empilement 2 de couches actives 20 de manière à atteindre le quatrième bord latéral 13 du substrat 1. L'étape b₄) est avantageusement exécutée par une quatrième découpe D4 du substrat 1 ajustée pour retirer la quatrième partie latérale 2d de l'empilement 2 de couches actives 20. La quatrième découpe D4 est exécutée dans la région périphérique Rp du substrat 1. La quatrième découpe D4 s'accompagne d'un retrait d'une quatrième zone latérale ZL4 du substrat 1 s'étendant dans la région périphérique Rp du substrat 1. Ainsi, le quatrième bord latéral 13 du substrat 1 atteint à l'issue de l'étape b₄) ne coïncide pas parfaitement avec le quatrième bord latéral 13 initial. A titre d'exemple non limitatif, la distance entre le quatrième bord latéral 13 initial et le quatrième bord latéral 13 atteint à l'issue de l'étape b₄) peut être comprise entre 250 µm et 1,5 mm pour un substrat 1 de 300 mm de côté. La quatrième découpe D4 est ajustée de sorte que la quatrième zone latérale ZL4 présente une superficie la plus faible possible. A titre d'exemples non limitatifs, la quatrième découpe D4 peut être exécutée par une technique de clivage laser (LDC pour « *Laser Direct Cleavage»* en langue anglaise), ou par une technique de séparation thermique au laser (TLS pour « *Thermal Laser Séparation* » en langue anglaise), ces techniques étant connues de l'homme du métier.

L'ordre d'exécution des étapes b₁), b₂), b₃) et b₄) est indifférent. Autrement dit, l'ordre d'exécution des étapes bᵢ), « i » étant un entier compris entre 2 et 4 selon le nombre de bords natifs retirés, est indifférent.

En outre, tout ou partie des étapes b₁), b₂), b₃) et b₄) peuvent être exécutées de manière concomitante. Autrement dit, au moins deux étapes parmi les étapes b₁), « i » étant un entier compris entre 2 et 4 selon le nombre de bords natifs retirés, peuvent être exécutées de manière concomitante.

### Formation de couche(s) de passivation

Le procédé comporte une étape c₁) consistant à former une première couche de passivation P1 sur le premier bord latéral 10 du substrat 1 atteint à l'issue de l'étape b₁). La première couche de passivation P1 possède une vitesse de recombinaison de surface effective strictement inférieure à SRV₀. Plus précisément, la première couche de passivation P1 possède une vitesse de recombinaison de surface effective strictement inférieure à celle de la couche de passivation initiale P0 des parties latérales 2a, 2b, 2c, 2d de l'empilement 2. Il est à noter que la vitesse de recombinaison de surface effective de la première couche de passivation P1 dépend de la technique de la première découpe D1 de l'étape b₁). A titre d'exemple non limitatif, lorsque la couche de passivation initiale P0 est réalisée dans un silicium amorphe hydrogéné, l'étape c₁) peut être exécutée de sorte que la première couche de passivation P1 est réalisée dans un oxyde d'aluminium. L'étape c₁) est exécutée par une technique de dépôt adaptée au matériau de la première couche de passivation P1. A titre d'exemple non limitatif, lorsque la première couche de passivation P1 est réalisée dans un oxyde d'aluminium, l'étape c₁) peut être exécutée par un dépôt de couches atomiques (ALD pour « *Atomic Layer Déposition* » en langue anglaise) avec un recuit thermique à une température comprise entre 100°C et 600°C. A titre d'exemple non limitatif, le premier bord latéral 10 du substrat 1 atteint à l'issue de l'étape b₁), passivé par la première couche de passivation P1, peut présenter une densité de défauts à l'interface (« Dit », densité d'états d'interface) inférieure ou égale à 10⁹.

Le procédé comporte avantageusement une étape c₂) consistant à former une deuxième couche de passivation P2 sur le deuxième bord latéral 11 du substrat 1 atteint à l'issue de l'étape b₂). La deuxième couche de passivation P2 possède une vitesse de recombinaison de surface effective strictement inférieure à SRV₀. Plus précisément, la deuxième couche de passivation P2 possède une vitesse de recombinaison de surface effective strictement inférieure à celle de la couche de passivation initiale P0 des parties latérales 2a, 2b, 2c, 2d de l'empilement 2. Il est à noter que la vitesse de recombinaison de surface effective de la deuxième couche de passivation P2 dépend de la technique de la deuxième découpe D2 de l'étape b₂). A titre d'exemple non limitatif, lorsque la couche de passivation initiale P0 est réalisée dans un silicium amorphe hydrogéné, l'étape c₂) peut être exécutée de sorte que la deuxième couche de passivation P2 est réalisée dans un oxyde d'aluminium. L'étape c₂) est exécutée par une technique de dépôt adaptée au matériau de la deuxième couche de passivation P2. A titre d'exemple non limitatif, lorsque la deuxième couche de passivation P2 est réalisée dans un oxyde d'aluminium, l'étape c₂) peut être exécutée par un dépôt de couches atomiques (ALD pour « *Atomic Layer Déposition* » en langue anglaise) avec un recuit thermique à une température comprise entre 100°C et 600°C. A titre d'exemple non limitatif, le deuxième bord latéral 11 du substrat 1 atteint à l'issue de l'étape b₂), passivé par la deuxième couche de passivation P2, peut présenter une densité de défauts à l'interface (« Dit », densité d'états d'interface) inférieure ou égale à 10⁹.

Le procédé comporte avantageusement une étape c₃) consistant à former une troisième couche de passivation P3 sur le troisième bord latéral 12 du substrat 1 atteint à l'issue de l'étape b₃). La troisième couche de passivation P3 possède une vitesse de recombinaison de surface effective strictement inférieure à SRV₀. Plus précisément, la troisième couche de passivation P3 possède une vitesse de recombinaison de surface effective strictement inférieure à celle de la couche de passivation initiale P0 des parties latérales 2a, 2b, 2c, 2d de l'empilement 2. Il est à noter que la vitesse de recombinaison de surface effective de la troisième couche de passivation P3 dépend de la technique de la troisième découpe D3 de l'étape b₃). A titre d'exemple non limitatif, lorsque la couche de passivation initiale P0 est réalisée dans un silicium amorphe hydrogéné, l'étape c₃) peut être exécutée de sorte que la troisième couche de passivation P3 est réalisée dans un oxyde d'aluminium. L'étape c₃) est exécutée par une technique de dépôt adaptée au matériau de la troisième couche de passivation P3. A titre d'exemple non limitatif, lorsque la troisième couche de passivation P3 est réalisée dans un oxyde d'aluminium, l'étape c₃) peut être exécutée par un dépôt de couches atomiques (ALD pour *« Atomic Layer Déposition* » en langue anglaise) avec un recuit thermique à une température comprise entre 100°C et 600°C. A titre d'exemple non limitatif, le troisième bord latéral 12 du substrat 1 atteint à l'issue de l'étape b₃), passivé par la troisième couche de passivation P3, peut présenter une densité de défauts à l'interface (« Dit », densité d'états d'interface) inférieure ou égale à 10⁹.

Le procédé comporte avantageusement une étape c₄) consistant à former une quatrième couche de passivation P4 sur le quatrième bord latéral 13 du substrat 1 atteint à l'issue de l'étape b₄). La quatrième couche de passivation P4 possède une vitesse de recombinaison de surface effective strictement inférieure à SRV₀. Plus précisément, la quatrième couche de passivation P4 possède une vitesse de recombinaison de surface effective strictement inférieure à celle de la couche de passivation initiale P0 des parties latérales 2a, 2b, 2c, 2d de l'empilement 2. Il est à noter que la vitesse de recombinaison de surface effective de la quatrième couche de passivation P4 dépend de la technique de la quatrième découpe D4 de l'étape b₄). A titre d'exemple non limitatif, lorsque la couche de passivation initiale P0 est réalisée dans un silicium amorphe hydrogéné, l'étape c₄) peut être exécutée de sorte que la quatrième couche de passivation P4 est réalisée dans un oxyde d'aluminium. L'étape c₄) est exécutée par une technique de dépôt adaptée au matériau de la quatrième couche de passivation P4. A titre d'exemple non limitatif, lorsque la quatrième couche de passivation P4 est réalisée dans un oxyde d'aluminium, l'étape c₄) peut être exécutée par un dépôt de couches atomiques (ALD pour *« Atomic Layer Déposition* » en langue anglaise) avec un recuit thermique à une température comprise entre 100°C et 600°C. A titre d'exemple non limitatif, le quatrième bord latéral 13 du substrat 1 atteint à l'issue de l'étape b₄), passivé par la quatrième couche de passivation P4, peut présenter une densité de défauts à l'interface (« Dit », densité d'états d'interface) inférieure ou égale à 10⁹.

L'ordre d'exécution des étapes c₁), c₂), c₃) et c₄) est indifférent. Autrement dit, l'ordre d'exécution des étapes cᵢ), « i » étant un entier compris entre 2 et 4 selon le nombre de bords natifs retirés, est indifférent.

En outre, tout ou partie des étapes c₁), c₂), c₃) et c₄) peuvent être exécutées de manière concomitante. Autrement dit, au moins deux étapes parmi les étapes cᵢ), « i » étant un entier compris entre 2 et 4 selon le nombre de bords natifs retirés, peuvent être exécutées de manière concomitante.

Les matériaux des première, deuxième, troisième et quatrième couches de passivation P1, P2, P3, P4 sont avantageusement identiques.

### Obtention de sous-cellules photovoltaïques

Le procédé comporte avantageusement une étape d) consistant à découper le substrat 1 suivant au moins une ligne de découpe L1, L2 s'étendant dans la région centrale Rc de manière à obtenir au moins deux sous-cellules C photovoltaïques. A titre d'exemples non limitatifs, l'étape d) peut être exécutée par une technique de clivage laser (LDC pour « *Laser Direct Cleavage»* en langue anglaise), ou par une technique de séparation thermique au laser (TLS pour « *Thermal Laser Separation »* en langue anglaise), ces techniques étant connues de l'homme du métier. L'étape d) est avantageusement exécutée de manière à obtenir au moins deux sous-cellules C photovoltaïques possédant des superficies identiques.

L'étape d) est avantageusement exécutée de sorte que ladite au moins une ligne de découpe L1, L2 est parallèle à la normale aux surfaces supérieure et inférieure du substrat 1.

On choisira le nombre de lignes de découpe L1, L2 en fonction du nombre de sous-cellules C photovoltaïques souhaitées et de leur format souhaité.

L'étape d) est avantageusement exécutée après les étapes b₁), b₂), b₃) et b₄). Autrement dit, l'étape d) est avantageusement exécutée après les étapes bᵢ), « i » étant un entier compris entre 1 et 4 selon le nombre de bords natifs retirés.

L'étape d) est avantageusement exécutée avant les étapes c₁), c₂), c₃) et c₄). Autrement dit, l'étape d) est avantageusement exécutée avant les étapes cᵢ), « i » étant un entier compris entre 1 et 4 selon le nombre de bords natifs retirés.

Lesdites au moins deux sous-cellules C photovoltaïques présentent des bords découpés à l'issue de l'étape d). Le procédé comporte avantageusement une étape e) consistant à revêtir chaque bord découpé à l'issue de l'étape d) d'une couche de passivation P' possédant une vitesse de recombinaison de surface effective strictement inférieure à SRV₀. Plus précisément, la couche de passivation P' possède une vitesse de recombinaison de surface effective strictement inférieure à celle de la couche de passivation initiale P0 des parties latérales 2a, 2b, 2c, 2d de l'empilement 2.

Lorsque l'étape d) est exécutée avant les étapes c₁), c₂), c₃) et c₄), alors l'étape e) est avantageusement exécutée de manière concomitante avec les étapes c₁), c₂), c₃) et c₄). La couche de passivation P' de l'étape e) est avantageusement réalisée dans le même matériau que les première, deuxième, troisième et quatrième couches de passivation P1, P2, P3, P4.

L'invention ne se limite pas aux modes de réalisation exposés. L'homme du métier est mis à même de considérer leurs combinaisons techniquement opérantes, et de leur substituer des équivalents.

## Revendications

1. Procédé de fabrication d'une cellule photovoltaïque, comportant les étapes :
a) utiliser une cellule photovoltaïque initiale, comprenant :
- un substrat (1), à base de silicium cristallin, et présentant :
des premier et deuxième bords latéraux (10, 11) opposés,
des troisième et quatrième bords latéraux (12, 13) opposés, reliant les premier et deuxième bords latéraux (10, 11) ;
- un empilement (2) de couches actives (20), formé autour du substrat (1), et comprenant une couche de passivation initiale (P0) possédant une vitesse de recombinaison de surface effective, notée SRV₀ ; l'empilement (2) présentant :
des première et deuxième parties latérales (2a, 2b), s'étendant respectivement sur les premier et deuxième bords latéraux (10, 11) du substrat (1),
des troisième et quatrième parties latérales (2c, 2d), s'étendant respectivement sur les troisième et quatrième bords latéraux (12, 13) du substrat (1) ;
b₁) retirer la première partie latérale (2a) de l'empilement (2) de couches actives (20) de manière à atteindre le premier bord latéral (10) du substrat (1) ;
c₁) former une première couche de passivation (P1) sur le premier bord latéral (10) du substrat (1) atteint à l'issue de l'étape b₁), la première couche de passivation (P1) possédant une vitesse de recombinaison de surface effective strictement inférieure à SRV₀.

2. Procédé selon la revendication 1, comportant les étapes :
b₂) retirer la deuxième partie latérale (2b) de l'empilement (2) de couches actives (20) de manière à atteindre le deuxième bord latéral (11) du substrat (1) ;
c₂) former une deuxième couche de passivation (P2) sur le deuxième bord latéral (11) du substrat (1) atteint à l'issue de l'étape b₂), la deuxième couche de passivation (P2) possédant une vitesse de recombinaison de surface effective strictement inférieure à SRV₀.

3. Procédé selon la revendication 1 ou 2, comportant les étapes :
b₃) retirer la troisième partie latérale (2c) de l'empilement (2) de couches actives (20) de manière à atteindre le troisième bord latéral (12) du substrat (1) ;
c₃) former une troisième couche de passivation (P3) sur le troisième bord latéral (12) du substrat (1) atteint à l'issue de l'étape b₃), la troisième couche de passivation (P3) possédant une vitesse de recombinaison de surface effective strictement inférieure à SRV₀.

4. Procédé selon l'une des revendications 1 à 3, comportant les étapes :
b₄) retirer la quatrième partie latérale (2d) de l'empilement (2) de couches actives (20) de manière à atteindre le quatrième bord latéral (13) du substrat (1) ;
c₄) former une quatrième couche de passivation (P4) sur le quatrième bord latéral (13) du substrat (1) atteint à l'issue de l'étape b₄), la quatrième couche de passivation (P4) possédant une vitesse de recombinaison de surface effective strictement inférieure à SRV₀.

5. Procédé selon l'une des revendications 1 à 4, dans lequel :
- l'étape a) est exécutée de sorte que l'empilement (2) de couches actives (20) comprend une couche d'oxyde transparent conducteur (200) superficielle présentant un décrochement initial, en retrait par rapport à chaque bord latéral (10, 11, 12, 13) du substrat (1), le décrochement initial étant de préférence obtenu par détourage ;
- l'étape b₁) est exécutée par une première découpe (D1) du substrat (1) ajustée pour retirer la première partie latérale (2a) de l'empilement (2) de couches actives (20) et une première zone latérale (ZL1) du substrat (1), de sorte que le premier bord latéral (10) du substrat (1) atteint à l'issue de la première découpe (D1) fait face au décrochement initial de la couche d'oxyde transparent conducteur (200) superficielle.

6. Procédé selon la revendication 5 en combinaison avec la revendication 2, dans lequel l'étape b₂) est exécutée par une deuxième découpe (D2) du substrat (1) ajustée pour retirer la deuxième partie latérale (2b) de l'empilement (2) de couches actives (20) et une deuxième zone latérale (ZL2) du substrat (1), de sorte que le deuxième bord latéral (11) du substrat (1) atteint à l'issue de la deuxième découpe (D2) fait face au décrochement initial de la couche d'oxyde transparent conducteur (200) superficielle.

7. Procédé selon la revendication 5 ou 6 en combinaison avec la revendication 3, dans lequel l'étape b₃) est exécutée par une troisième découpe (D3) du substrat (1) ajustée pour retirer la troisième partie latérale (2c) de l'empilement (2) de couches actives (20) et une troisième zone latérale (ZL3) du substrat (1), de sorte que le troisième bord latéral (12) du substrat (1) atteint à l'issue de la troisième découpe (D3) fait face au décrochement initial de la couche d'oxyde transparent conducteur (200) superficielle.

8. Procédé selon l'une des revendications 5 à 7 en combinaison avec la revendication 4, dans lequel l'étape b₄) est exécutée par une quatrième découpe (D4) du substrat (1) ajustée pour retirer la quatrième partie latérale (2d) de l'empilement (2) de couches actives (20) et une quatrième zone latérale (ZL4) du substrat (1), de sorte que le quatrième bord latéral (13) du substrat (1) atteint à l'issue de la quatrième découpe (D4) fait face au décrochement initial de la couche d'oxyde transparent conducteur (200) superficielle.

9. Procédé selon l'une des revendications 1 à 8, dans lequel le substrat (1) de la cellule photovoltaïque initiale utilisée lors de l'étape a) présente :
- une région centrale (Rc),
- une région périphérique (Rp), s'étendant autour de la région centrale (Rp), comprenant les premier et deuxième bords latéraux (10, 11) ainsi que les troisième et quatrième bords latéraux (12, 13) ;
le procédé comportant une étape d) consistant à découper le substrat (1) suivant au moins une ligne de découpe (L1, L2) s'étendant dans la région centrale (Rc) de manière à obtenir au moins deux sous-cellules (C) photovoltaïques.

10. Procédé selon la revendication 9, dans lequel lesdites au moins deux sous-cellules (C) photovoltaïques présentent des bords découpés à l'issue de l'étape d) ; le procédé comportant une étape e) consistant à revêtir chaque bord découpé à l'issue de l'étape d) d'une couche de passivation (P') possédant une vitesse de recombinaison de surface effective strictement inférieure à SRV₀.

11. Procédé selon l'une des revendications 1 à 10, dans lequel l'étape a) est exécutée de sorte que la couche de passivation initiale (P0) est réalisée dans un silicium amorphe hydrogéné ; et l'étape c₁) est exécutée de sorte que la première couche de passivation (P1) est réalisée dans un oxyde d'aluminium.
